(19) Europäisches Patentamt / European Patent Office / Office européen des brevets

(11) **EP 4 277 099 A1**

(12) **EUROPEAN PATENT APPLICATION**

(43) Date of publication:
**15.11.2023 Bulletin 2023/46**

(21) Application number: **23171951.9**

(22) Date of filing: **05.05.2023**

(51) International Patent Classification (IPC):
**H02M 1/00** (2006.01)   **H02M 3/158** (2006.01)
**H02M 3/07** (2006.01)

(52) Cooperative Patent Classification (CPC):
**H02M 3/072; H02M 1/007; H02M 1/0077;
H02M 3/158**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **10.05.2022 IN 202241026864**

(71) Applicant: **Goodrich Aerospace Services Private
Limited
560048 Bangalore (IN)**

(72) Inventors:
• **SOMANI, Vaibhav Kumar
560087 Bangalore (IN)**
• **HANUMAN, Kumbha Veera
523184 Prakasam (IN)**

(74) Representative: **Dehns
St. Bride's House
10 Salisbury Square
London EC4Y 8JD (GB)**

(54) **HIGH VOLTAGE DC-DC CONVERTERS**

(57)    A system (100) includes a DC-DC converter (102). The DC-DC converter (102) includes a first stage (106) configured to reduce DC input voltage to the DC-DC converter (102) an intermediate voltage, and a second stage (108) configured to reduce the intermediate voltage from the first stage (106) to a DC output voltage for output from the DC-DC converter (102). A controller (104) is operatively connected to control the DC-DC converter (102) for converting the DC input voltage to the DC output voltage.

Fig. 1

EP 4 277 099 A1

## Description

## Technical Field

The present disclosure relates to power converters, and more particularly to DC-DC converters for DC-DC power conversion.

## Background

DC-DC converters step down an input DC voltage to a lower DC output voltage. The aerospace industry has been trending towards electrification of aircraft, i.e. the more-electric aircraft. When the DC input is at a high voltage, the DC-DC converter must perform HVDC-DC conversion. The HVDC-DC conversion has an important role in this electrification process that typically step downs the high voltage (e.g. 800V-1000V) to Low voltage (e.g. 28V).

Typically for HVDC-DC conversion, an LLC bridge resonant converter can be used but this requires many switches (e.g., 8), and magnetics are involved too which causes extra power loss and requires more components. For this type of high voltage step down conversion there are two main problems.

First is the high voltage stress on the switches. For a simple DC-DC converter working on this high voltage level, the converter switches have to withstand a high voltage stress which is equal to the input DC voltage (800V/1000V). There are no or very few options of MOSFET/ IGBT available for 1600V-2000V range that can meet all the operating requirements.

Second is low duty cycle/ controllability issue. To get this large voltage attenuation with a DC-DC converter, the duty cycle required is very low. This demands a high resolution of the control signal, e.g. with pulse width modulation (PWM).

The conventional techniques have been considered satisfactory for their intended purpose. However, there is an ever present need for improved systems and methods for high voltage DC-DC power conversion. This disclosure provides a solution for this need.

## SUMMARY

In accordance with an aspect, a system is provided that includes a DC-DC converter. The DC-DC converter includes a first stage configured to reduce DC input voltage to the DC-DC converter down to an intermediate voltage, and a second stage configured to reduce the intermediate voltage from the first stage to a DC output voltage for output from the converter. A controller is operatively connected to control the DC-DC converter for converting the DC input voltage to the DC output voltage.

The first stage can include a first switch operatively connected to be controlled by the controller, a second switch operatively connected to be controlled by the controller, a first input capacitor, and a second input capacitor. The first input capacitor and the second input capacitor can be operatively connected to the first switch and to the second switch to reduce voltage stress on the first switch and the second switch so that neither of the first switch nor the second switch is exposed to more than half of the DC input voltage. The intermediate voltage can be half of the DC input voltage. The first stage, second stage, and controller can be configured to convert a DC input voltage of 800V or more to a DC output voltage of 28V.

The first stage can include a first line electrically connected to a positive DC input node of the DC-DC converter. The first switch can be connected in series in the first line. The first input capacitor can connect to the first line at a first capacitor input node. The first switch can be in series between the positive DC input node and the first capacitor input node. The second switch can be in series between the first input capacitor and a negative DC input node of the DC-DC converter.

A third switch can be connected to the first line in parallel with the first input capacitor. The third switch can be operatively connected to be controlled by the controller. The second input capacitor can be connected in series between the third switch and the negative DC input node. A diode can connect a first diode node between the first input capacitor and the second switch to a second diode node between the third switch and the second input capacitor. The diode can be oriented to allow current flow from the first diode node to the second diode node. The first stage can be connected to the second stage at the second diode node.

The second stage can include a fourth switch, a fifth switch, a sixth switch, and a seventh switch. The controller can include logic configured to cycle the first through seventh switches in three states for positive output voltage from the DC-DC converter. The first state can be a switching state wherein the first switch is on, the second switch is off, the third switch is off, the fourth switch is off, the fifth switch is on, the sixth switch is off, and the seventh switch is on. The second state can be a switching state wherein the first switch is off, the second switch is on, the third switch is on, the fourth switch is on, the fifth switch is off, the sixth switch is off, and the seventh switch is on. The third state can be a switching state wherein the first switch is off, the second switch is on, the third switch is on, the fourth switch is on, the fifth switch is off, the sixth switch is on, and the seventh switch is off. For each cycle through the three states, the first state can be held for a first duration, $(1-D_2)T$ wherein $D_2$ is a first duty cycle, wherein the second state is held for a second duration after the first duration, wherein the second duration is $(1-D_1)T-(1-D_2)T$, where $D_1$ is a second duty cycle, and wherein the third state is held for a duration $D_1*T$ after the second duration, wherein $D_1$ is less than $D_2$.

The controller can include logic configured to cycle the first through seventh switches in three states for negative output voltage from the DC-DC converter. The first state can be a switching state wherein the first switch is on, the second switch is off, the third switch is off, the fourth switch is off, the fifth switch is on, the sixth switch is off, and the seventh switch is on. The second state can be a switching state wherein the first switch is off, the second switch is on, the third switch is on, the fourth switch is off, the fifth switch is on, the sixth switch is on, and the seventh switch is off. The third state can be a switching state wherein the first switch is off, the second switch is on, the third switch is on, the fourth switch is on, the fifth switch is off, the sixth switch is on, and the seventh switch is off. For each cycle through the three states, the first state can be held for a first duration, $(1-D_1)T$ wherein $D_1$ is a first duty cycle, wherein the second state is held for a second duration after the first duration, wherein the second duration is $(1-D_2)T-(1-D_1)T$, where $D_2$ is a second duty cycle, and wherein the third state is held for a duration $D_2*T$ after the second duration, wherein $D_1$ is greater than $D_2$.

These and other features of the systems and methods of the subject disclosure will become more readily apparent to those skilled in the art from the following detailed description of the preferred embodiments taken in conjunction with the drawings.

## BRIEF DESCRIPTION OF THE DRAWINGS

So that those skilled in the art to which the subject disclosure appertains will readily understand how to make and use the devices and methods of the subject disclosure without undue experimentation, preferred embodiments thereof will be described in detail herein below with reference to certain figures, wherein:

Fig. 1 is a schematic view of an embodiment of a system constructed in accordance with the present disclosure, showing the first and second stages of the DC-DC converter, as well as the controller for controlling the switches of the first and second stages;

Fig. 2 is a schematic view of the system of Fig. 1, showing the portions of the first and second stages that are active in the first switching state;

Fig. 3 is a schematic view of the system of Fig. 1, showing the portions of the first and second stages that are active in the second switching state; and

Fig. 4 is a schematic view of the system of Fig. 1, showing the portions of the first and second stages that are active in the third switching state.

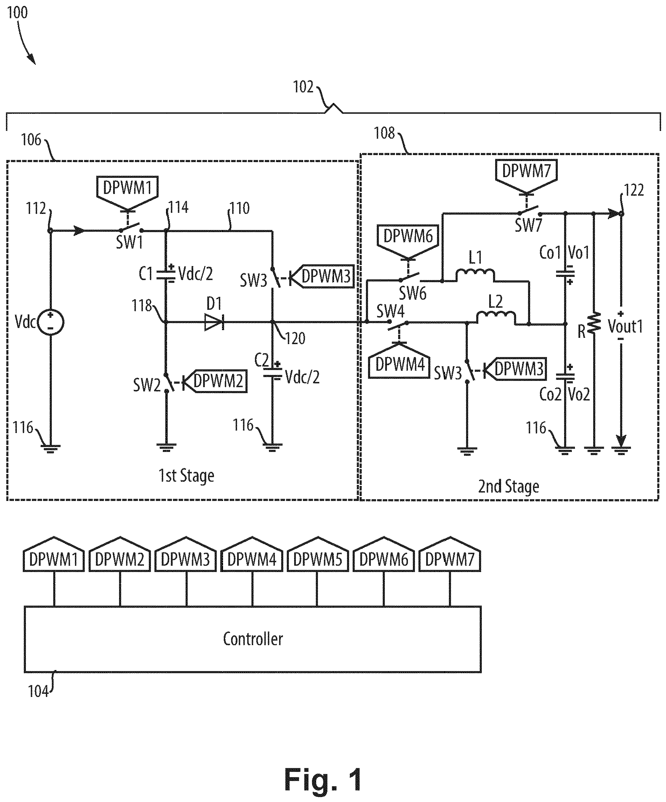

TABLE 1 is a table showing the three switch states for the seven switches of the system of Fig. 1 for producing positive output, i.e. where the voltage output from the DC-DC converter has the same polarity as the voltage input to the DC-DC converter.

TABLE 2 is a table showing the three switch states for the seven switches of the system of Fig. 1 for producing negative output, i.e. where the voltage output from the DC-DC converter has the opposite polarity from the voltage input to the DC-DC converter.

TABLE 3 below summarizes the duration of the thee states for both positive and negative output, TABLE 4 shows the durations of the states for the positive output mode, and TABLE 5 shows the durations of the sates for negative output mode.

## DETAILED DESCRIPTION

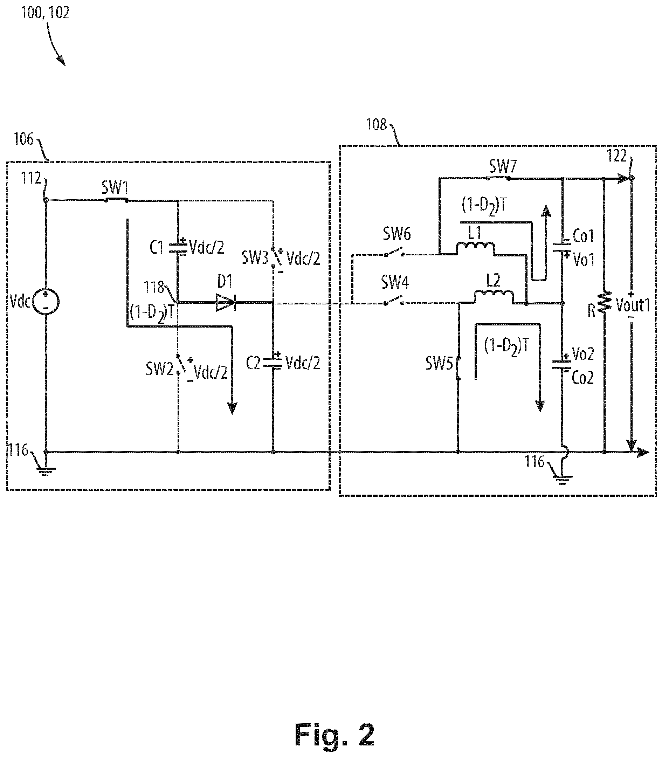

Reference will now be made to the drawings wherein like reference numerals identify similar structural features or aspects of the subject disclosure. For purposes of explanation and illustration, and not limitation, a partial view of an embodiment of a system in accordance with the disclosure is shown in Fig. 1 and is designated generally by reference character 100. Other embodiments of systems in accordance with the disclosure, or aspects thereof, are provided in Figs. 2-4, as will be described. The systems and methods described herein can be used for high voltage DC-DC power conversion, such as in DC-DC converters for stepping down generator output to aircraft system voltage.

The system 100 includes a DC-DC converter 102 and a controller 104. The DC-DC converter 102 includes a first stage 106 configured to reduce DC input voltage to the DC-DC converter 102 down to an intermediate voltage. The DC-DC converter 102 includes a second stage 108 configured to reduce the intermediate voltage from the first stage 106 to a DC output voltage for output from the DC-DC converter 102. The controller 104 is operatively connected to control the DC-DC converter 102 for converting the DC input voltage to the DC output voltage. For example, the intermediate voltage can be half of the DC input voltage. The first stage 106, second stage 108, and controller 104 can be configured to convert a DC input voltage of 800V or more to a DC output voltage of 28V DC, for example to condition power form a generator aboard an aircraft for use by most or all of the aircraft's electrical components.

The first stage 106 includes a first switch SW1, a second switch SW2, and a third switch SW3 all operatively connected to be controlled by the controller 104. The first stage also includes a first input capacitor C1 and a second input capacitor C2. C1 and C2 are of equal capacitance, and the first stage 106 develops half of the input voltage (Vdc in Fig. 1) across the input capacitors C1 and C2. The first and second input capacitors C1, C2 are operatively connected to the first and second switches SW1, SW2 to reduce voltage stress on the first and second switches SW1, SW2 so that neither of the first and second switches SW1, SW2 is exposed to more than half of the DC input voltage of the DC-DC converter 102.

The first stage 106 includes a first line 110 electrically connected to a positive DC input node 112 of the DC-DC converter 102. The first switch SW1 is connected in series in the first line 110. The first input capacitor C1 connects to the first line 110 at a first capacitor input node 114. The first switch SW1 is in series between the positive DC input node 112 and the first capacitor input node 114. The second switch SW2 is in series between the first input capacitor C1 and a negative DC input node 116 of the DC-DC converter 102.

The third switch SW3 is connected to the first line 110 in parallel with the first input capacitor C1. The third switch SW3 is operatively connected to be controlled by the controller 104. The second input capacitor C2 is connected in series between the third switch SW3 and the negative DC input node 116. A diode D1 connects a first diode node 118 to a second diode node 120. The first diode node 118 is between the first input capacitor C1 and the second switch SW2. The second diode node 120 is between the third switch SW3 and the second input capacitor C2. The diode $D_1$ is oriented to allow current flow from the first diode node 118 to the second diode node 120. The first stage 106 is connected to the second stage 108 at the second diode node 120.

The second stage 108 includes a fourth switch SW4, a fifth switch SW5, a sixth switch SW6, a seventh switch SW7, a first inductor L1, a second inductor L2, a first output capacitor Co1, a second output capacitor Co2, and a DC output voltage node 122 all connected as shown in Fig. 1, wherein the switches are all connected to the controller 104 for controlling switching states. The resistor R in Fig. 1 represents the DC load receiving the DC power output from the DC-DC converter 102. In the second stage 108, half of the input voltage across the input capacitors C1 and C2 (Vdc/2) is fed as the input to the converter that is in the second stage 108. The converter generates output voltage across its two series capacitors Co1 and Co2. Either positive or negative output voltage Vout can be generated as it is a vector sum of the voltages across capacitors Co1 and Co2. The voltage stress across each switch SW4-SW7 becomes Vdc/2 with the front end capacitors C1 and C2 in this topology operated at a flexible/desired duty cycle for any level of conversion.

The controller 104 includes logic configured to cycle the first through seventh switches SW1-SW7 in three states for positive output voltage from the DC-DC converter 102, i.e. where the voltage output from the DC-DC converter 102 (Vout in Fig. 1) has the same polarity as the voltage input to the DC-DC converter 102 (Vdc in Fig. 1). These three switching states are shown in TABLE 1.

With reference now to Fig. 2, the switches SW1-SW7 are shown in the first state of TABLE 1, and also schematically indicates which parts of the DC-DC converter 102 are active in the first state, including current flow direction in the first and second stages 106, 108. For stage 1 the switch SW1 is on and the diode $D_1$ gets forward bias. During this state two input capacitors C1 and C2 are connected in series through diode D1 and both capacitors C1 and C2 are charged with a voltage of $V_{DC}/2$. During this same duration, there is a freewheeling action and the switch SW7 is on, which connects the inductor L1 across capacitor Co1 and develops a negative voltage across it as shown in Fig. 2. The switch SW5 is on, which connects the inductor L2 across capacitor Co2 and develops a positive voltage across it as shown in Fig. 2.

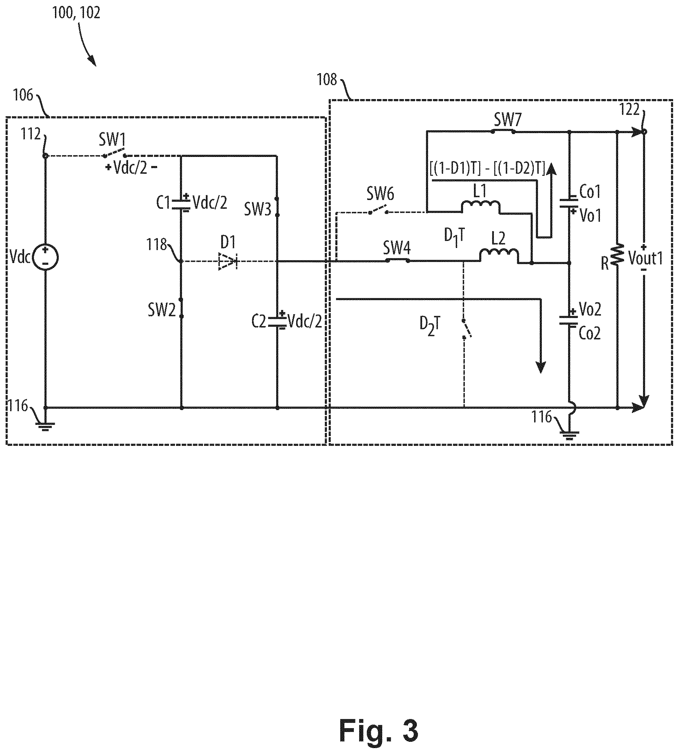

Fig. 3 similarly shows the switches SW1-SW7 in the second stage, with the current flow through the second stage 108 shown schematically. For the period of the second state, the switches SW2 and SW3 are on and the diode D1 gets reverse bias. During this state two input capacitors C1 and C2 are connected in parallel and both capacitors C1 and C2 act as an input at Vdc/2 for the second stage 108. In the stage 108, the switch SW7 remains on and SW6 is changed to the off state. This still connects the inductor L1 across Co1 to release the energy, while the switch SW4 is on and the switch SW5 is off for the period and the inductor L2 stores energy through capacitor Co2 as shown in Fig. 3.

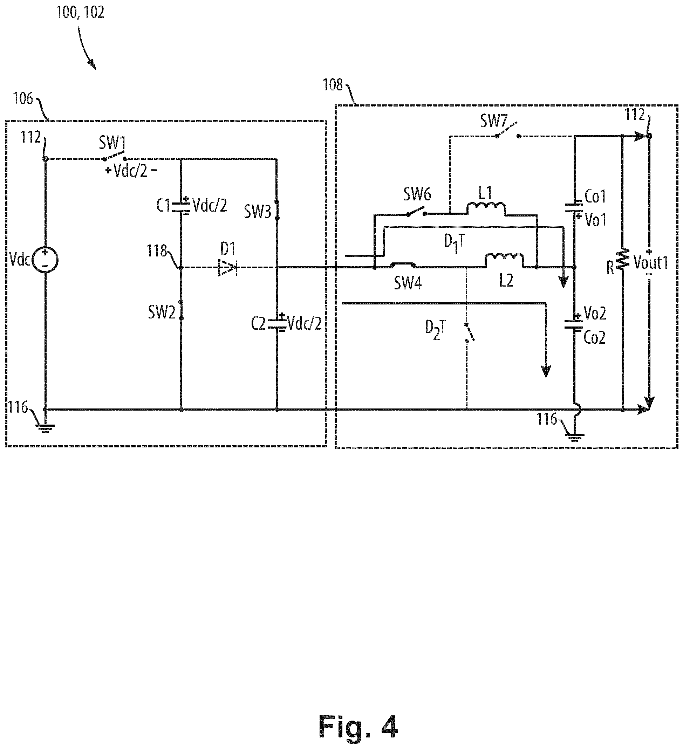

Fig. 4 shows the switches SW1-SW7 in the third stage of TABLE 1, as well as the current flow direction in the second stage 108. For the period of State 3, the switches SW2 and SW3 are on and the diode $D_1$ gets reverse bias. During this state, the two input capacitors C1 and C2 are connected in parallel and now both capacitors acts as an input at Vdc/2 for the second stage 108. In the second stage 108, the switch SW4 remains on and the switch SW5 remains off. The switch SW7 is changed to off and the switch SW6 is on. This connects the inductor L1 in parallel with inductor L2 and together they store the energy through the capacitor Co2. The other charged capacitor Co1 discharges its energy through load.

For each cycle through the three states, the first state is held for a first duration, $(1-D_2)T$ wherein $D_2$ is a first duty cycle, wherein the second state is held for a second duration after the first duration, wherein the second duration

is (1-$D_1$)T-(1-$D_2$)T or ($D_2$-$D_1$)T, where $D_1$ is a second duty cycle, and wherein the third state is held for a duration $D_1*$T after the second duration, wherein $D_1$ is less than $D_2$. The output voltage Vout can determined by the following formula.

$$V_{OUT} = \frac{D2 - D1}{1 - D1} * \frac{V_{dc}}{2}$$

In the 2nd stage 108, there are two converters in parallel, a top converter which generates a negative output of Vo1 and a bottom converter which generates the positive output Vo2. The top converter has two switches SW6 and SW7, and work on complementary on/off state. The duty ration of switch SW6 is defined as $D_1$ in the formulae for state durations above. The bottom converter has two switches SW4 and SW5, and work on complementary on/off state. The duty ration of switch SW4 is defined as $D_2$ for the state duration formulae above. The DC output of the converter 102 can be either positive or negative. For positive DC output, the duty cycles can be set so $D_2$ > $D_1$. For negative DC output, the duty cycles can be set so $D_1$ > $D_2$. Table 3 below summarizes the duration of the three states for both positive and negative output. Table 4 shows the durations of the states for the positive output mode, and Table 5 shows the durations of the sates for negative output mode.

The controller 104 can include logic configured to cycle the switches SW1-SW7 in three states for negative output voltage from the DC-DC converter, i.e. where the voltage output from the DC-DC converter 102 (Vout in Fig. 1) has the opposite polarity from the voltage input to the DC-DC converter 102 (Vdc in Fig. 1). TABLE 2 shows the three switch states for switches SW1-SW7 for the negative output mode. States 1 and 3 are the same as for the positive output mode described above with reference to TABLE 1 and Figs 2-4. State 2 in TABLE 2 is opposite for each switch SW4-SW7 from State 2 in TABLE 1. The timing for the duration of each state in the negative mode of TABLE 2 can be determined by the same formulae given above for TABLE 1, however, in the negative output mode of TABLE 2, $D_1$ is greater than $D_2$.

The systems and methods disclosed herein provide potential benefits described in this paragraph. A high voltage DC-DC converter architecture as disclosed herein has voltage stress across all switches less than or equal to Vdc/2 which is 50% compared to traditional converters. Systems and methods as disclosed herein can generate output voltage at comparatively higher duty cycle of control signal relative to traditional converters. In systems and methods disclosed herein, output is a vector sum of a positive and negative voltage. Desired output with either polarity can be generated by controlling the voltage across two output capacitors. The switching sequences disclosed herein enable a configurable polarity output.

As will be appreciated by those skilled in the art, aspects of the present embodiments may be embodied as a system, method or computer program product. Accordingly, aspects of the present embodiments may take the form of an entirely hardware embodiment, an entirely software embodiment (including firmware, resident software, micro-code, etc.) or an embodiment combining software and hardware aspects that may all generally be referred to herein as a "circuit," "module," "component" or "system." Furthermore, aspects of the present disclosure may take the form of a computer program product embodied in one or more computer readable medium(s) having computer readable program code embodied thereon.

Any combination of one or more computer readable medium(s) may be utilized. The computer readable medium may be a computer readable signal medium or a computer readable storage medium. A computer readable storage medium may be, for example, but not limited to, an electronic, magnetic, optical, electromagnetic, infrared, or semiconductor system, apparatus, or device, or any suitable combination of the foregoing. More specific examples (a non-exhaustive list) of the computer readable storage medium would include the following: an electrical connection having one or more wires, a portable computer diskette, a hard disk, a random access memory (RAM), a read-only memory (ROM), an erasable programmable read-only memory (EPROM or Flash memory), an optical fiber, a portable compact disc read-only memory (CD-ROM), an optical storage device, a magnetic storage device, or any suitable combination of the foregoing. In the context of this document, a computer readable storage medium may be any tangible medium that can contain, or store a program for use by or in connection with an instruction execution system, apparatus, or device.

A computer readable signal medium may include a propagated data signal with computer readable program code embodied therein, for example, in baseband or as part of a carrier wave. Such a propagated signal may take any of a variety of forms, including, but not limited to, electro-magnetic, optical, or any suitable combination thereof. A computer readable signal medium may be any computer readable medium that is not a computer readable storage medium and that can communicate, propagate, or transport a program for use by or in connection with an instruction execution system, apparatus, or device.

Program code embodied on a computer readable medium may be transmitted using any appropriate medium, including but not limited to wireless, wireline, optical fiber cable, RF, etc., or any suitable combination of the foregoing.

Computer program code for carrying out operations for aspects of the present disclosure may be written in any combination of one or more programming languages, including an object oriented programming language such as Java, Smalltalk, C++ or the like and conventional procedural programming languages, such as the "C" programming language or similar programming languages. The program code may execute entirely on the user's computer, partly on the user's computer, as a stand-alone software package, partly on the user's computer and partly on a remote computer or entirely on the remote computer or server. In the latter scenario, the remote computer may be connected to the user's computer through any type of network, including a local area network (LAN) or a wide area network (WAN), or the connection may be made to an external computer (for example, through the Internet using an Internet Service Provider).

Aspects of the present disclosure are described above with reference to flowchart illustrations and/or block diagrams of methods, apparatus (systems) and computer program products according to embodiments of the embodiments. It will be understood that each block of the flowchart illustrations and/or block diagrams, and combinations of blocks in the flowchart illustrations and/or block diagrams, can be implemented by computer program instructions. These computer program instructions may be provided to a processor of a general purpose computer, special purpose computer, or other programmable data processing apparatus to produce a machine, such that the instructions, which execute via the processor of the computer or other programmable data processing apparatus, create means for implementing the functions/acts specified in the flowchart and/or block diagram block or blocks.

These computer program instructions may also be stored in a computer readable medium that can direct a computer, other programmable data processing apparatus, or other devices to function in a particular manner, such that the instructions stored in the computer readable medium produce an article of manufacture including instructions which implement the function/act specified in the flowchart and/or block diagram block or blocks.

The computer program instructions may also be loaded onto a computer, other programmable data processing apparatus, or other devices to cause a series of operational steps to be performed on the computer, other programmable apparatus or other devices to produce a computer implemented process such that the instructions which execute on the computer or other programmable apparatus provide processes for implementing the functions/acts specified in a flowchart and/or block diagram block or blocks.

The methods and systems of the present disclosure, as described above and shown in the drawings, provide for high voltage DC-DC power conversion, such as in DC-DC converters for stepping down generator output to aircraft system voltage. While the apparatus and methods of the subject disclosure have been shown and described with reference to preferred embodiments, those skilled in the art will readily appreciate that changes and/or modifications may be made thereto without departing from the scope of the subject disclosure.

TABLE 1

| Mode\Switch | S1 | S2 | S3 | S4 | S5 | S6 | S7 |
|---|---|---|---|---|---|---|---|
| STATE 1 | ON | OFF | OFF | OFF | ON | OFF | ON |
| STATE 2 | OFF | ON | ON | ON | OFF | OFF | ON |
| STATE 3 | OFF | ON | ON | ON | OFF | ON | OFF |

TABLE 2

| Mode\Switch | S1 | S2 | S3 | S4 | S5 | S6 | S7 |
|---|---|---|---|---|---|---|---|
| STATE 1 | ON | OFF | OFF | OFF | ON | OFF | ON |
| STATE 2 | ON | OFF | OFF | OFF | ON | ON | OFF |
| STATE 3 | OFF | ON | ON | ON | OFF | ON | OFF |

TABLE3

| Mode of operation | Duration of states | | |
|---|---|---|---|
| | State 1 | State 2 | State 3 |
| Positive DC Output (D2>D1) | (1-D2)*T | (D2-D1)*T | D1*T |
| Negative DC output (D1>D2) | (1-D1)*T | (D1-D2)*T | D2*T |

TABLE 4

| Positive DC Output (D2>D1) | | | |
|---|---|---|---|
| | (1-D2)*T | D2 *T | |
| | | | D1 *T |
| State | State 1 | State 2 | State 3 |
| Duration | (1-D2)*T | (D2-D1)*T | D1 *T |

TABLE5

| Negative DC output (D1>D2) | | | |
|---|---|---|---|
| | (1-D1)*T | | D2 *T |
| | | D1 *T | |
| State | State 1 | State 2 | State 3 |
| Duration | (1-D1)*T | (D1-D2)*T | D2*T |

**Claims**

1. A system comprising:

   a DC-DC converter including a first stage configured to reduce DC input voltage to the DC-DC converter down to an intermediate voltage, and a second stage configured to reduce the intermediate voltage from the first stage to a DC output voltage for output from the DC-DC converter; and
   a controller operatively connected to control the DC-DC converter for converting the DC input voltage to the DC output voltage.

2. The system as recited in claim 1, wherein the intermediate voltage is half of the DC input voltage.

3. The system as recited in claim 1 or 2, wherein the first stage, second stage, and controller are configured to convert a DC input voltage of 800V or more to a DC output voltage of 28V.

4. The system as recited in claim 1, 2 or 3, wherein the first stage includes:

   a first switch operatively connected to be controlled by the controller;
   a second switch operatively connected to be controlled by the controller;
   a first input capacitor; and
   a second input capacitor, wherein the first input capacitor and the second input capacitor are operatively connected to the first switch and to the second switch to reduce voltage stress on the first switch and the second switch so that neither of the first switch nor the second switch is exposed to more than half of the DC input voltage.

5. The system as recited in claim 4, wherein the first stage includes a first line electrically connected to a positive DC input node of the DC-DC converter, wherein the first switch is connected in series in the first line.

6. The system as recited in claim 5, wherein the first input capacitor connects to the first line at a first capacitor input node, wherein the first switch is in series between the positive DC input node and the first capacitor input node.

7. The system as recited in any of claims 4 to 6, wherein the second switch is in series between the first input capacitor and a negative DC input node of the DC-DC converter.

8. The system as recited in claim 7 when dependent on claim 5 or 6, further comprising a third switch connected to the first line in parallel with the first input capacitor, wherein the third switch is operatively connected to be controlled by the controller.

9. The system as recited in claim 8, wherein the second input capacitor is connected in series between the third switch and the negative DC input node.

10. The system as recited in any of claims 4 to 9, further comprising a diode connecting a first diode node between the first input capacitor and the second switch to a second diode node between the third switch and the second input capacitor, wherein the diode is oriented to allow current flow from the first diode node to the second diode node.

11. The system as recited in claim 10, wherein the first stage is connected to the second stage at the second diode node.

12. The system as recited in claim 11, wherein the second stage includes a fourth switch, a fifth switch, a sixth switch, and a seventh switch, wherein the controller includes logic configured to cycle the first through seventh switches in three states for positive output voltage from the DC-DC converter,

   wherein in the first state the first switch is on, the second switch is off, the third switch is off, the fourth switch is off, the fifth switch is on, the sixth switch is off, and the seventh switch is on;
   wherein in the second state the first switch is off, the second switch is on, the third switch is on, the fourth switch is on, the fifth switch is off, the sixth switch is off, and the seventh switch is on; and
   wherein in the third state the first switch is off, the second switch is on, the third switch is on, the fourth switch is on, the fifth switch is off, the sixth switch is on, and the seventh switch is off.

13. The system as recited in claim 12, wherein for each cycle through the three states, the first state is held for a first duration, $(1-D_2)T$ wherein $D_2$ is a first duty cycle, wherein the second state is held for a second duration after the first duration, wherein the second duration is $(1-D_1)T-(1-D_2)T$, where $D_1$ is a second duty cycle, and wherein the third state is held for a duration $D_1*T$ after the second duration, wherein $D_1$ is less than $D_2$.

14. The system as recited in claim 11, wherein the second stage includes a fourth switch, a fifth switch, a sixth switch, and a seventh switch, wherein the controller includes logic configured to cycle the first through seventh switches in three states for negative output voltage from the DC-DC converter,

   wherein in the first state the first switch is on, the second switch is off, the third switch is off, the fourth switch is off, the fifth switch is on, the sixth switch is off, and the seventh switch is on;
   wherein in the second state the first switch is off, the second switch is on, the third switch is on, the fourth switch is off, the fifth switch is on, the sixth switch is on, and the seventh switch is off; and
   wherein in the third state the first switch is off, the second switch is on, the third switch is on, the fourth switch is on, the fifth switch is off, the sixth switch is on, and the seventh switch is off.

15. The system as recited in claim 14, wherein for each cycle through the three states, the first state is held for a first duration, $(1-D_1)T$ wherein $D_1$ is a first duty cycle, wherein the second state is held for a second duration after the first duration, wherein the second duration is $(1-D_2)T-(1-D_1)T$, where $D_2$ is a second duty cycle, and wherein the third state is held for a duration $D_2*T$ after the second duration, wherein $D_1$ is greater than $D_2$.

**Fig. 1**

**Fig. 2**

**Fig. 3**

**Fig. 4**

Europäisches Patentamt
European Patent Office
Office européen des brevets

# EUROPEAN SEARCH REPORT

Application Number

EP 23 17 1951

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2017/196826 A1 (PEREGRINE SEMICONDUCTOR CORP [US]) 16 November 2017 (2017-11-16)<br>* abstract *<br>* page 31, line 26 – page 32, line 17; figures 47, 48 *<br>* page 27, line 21 – page 28, line 6; figures 39, 40 *<br>----- | 1-15 | INV.<br>H02M1/00<br>H02M3/158<br>H02M3/07 |

TECHNICAL FIELDS SEARCHED (IPC)

H02M

The present search report has been drawn up for all claims

| Place of search | Date of completion of the search | Examiner |
|---|---|---|
| The Hague | 19 September 2023 | Van der Meer, Paul |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

# EP 4 277 099 A1

## ANNEX TO THE EUROPEAN SEARCH REPORT
## ON EUROPEAN PATENT APPLICATION NO.

EP 23 17 1951

This annex lists the patent family members relating to the patent documents cited in the above-mentioned European search report.
The members are as contained in the European Patent Office EDP file on
The European Patent Office is in no way liable for these particulars which are merely given for the purpose of information.

19-09-2023

| Patent document cited in search report | | Publication date | Patent family member(s) | | Publication date |
|---|---|---|---|---|---|
| WO 2017196826 | A1 | 16-11-2017 | CN | 109478845 A | 15-03-2019 |
| | | | CN | 112838760 A | 25-05-2021 |
| | | | DE | 112017002374 T5 | 17-01-2019 |
| | | | WO | 2017196826 A1 | 16-11-2017 |

EPO FORM P0459

For more details about this annex : see Official Journal of the European Patent Office, No. 12/82